# EUROPEAN PATENT APPLICATION

(11) **EP 1 258 921 A2**
(43) Date of publication of application: **20.11.2002**
(21) Application number: 02010841.1
(22) Date of filing: 15.05.2002
(51) Int. Cl.: H01L 23/467

(54) **Angle mounted fan-sink**

(30) Priority: 15.05.2001 US 291525 P
(71) Applicant: Gateway, Inc., Poway, California 92064 (US)
(72) Inventor: Park, Jeekyoung, Tustin, CA 92782 (US)
(74) Representative: Viering, Jentschura & Partner

(57) **Abstract**

An angle-mounted tan sink for an electronic device, such as the processor of a computer system, or the like includes a heat sink coupled to a surface of the electronic device for conducting heat away from the electronic device. A fan assembly is mounted in an oblique orientation to the base of the heat sink. The fan assembly circulates a cooling medium such as air over the heat sink at an angle that is generally oblique to the surface of the electronic device for dissipating heat from the heat sink.

## Description

### CROSS-REFERENCE TO RELATED APPLICATIONS

The present application claims the benefit under 35 U.S.C. § 119(e) of U.S. Provisional Application No. 60/291,525, filed May 15, 2001. Said U.S. Provisional Application No. 60/291,525 is herein incorporated by reference in its entirety.

### FIELD OF THE INVENTION

The present invention generally relates to the field of cooling devices suitable for cooling electronic devices, and particularly to fan-sinks (i.e., active heat sinks) for cooling electronic devices such as processors mounted to the motherboard of a computer system, or the like.

### BACKGROUND OF THE INVENTION

A heat sink is a component designed to lower the temperature of or cool an electronic device, such as a computer processor, by dissipating heat into the surrounding air. One type of heat sink is a fan sink, also referred to as an active heat sink. The fan sink includes a heat sink with a fan attached to it. The fan circulates a cooling medium, typically air, over the heat sink in order to remove heat from the heat sink via forced air convection. Typically, the fan sink is mounted on top of the electronic device. The area in the center base of the fan sink, located immediately over the electronic device, usually heats up (*i.e*., the hot area or spot).

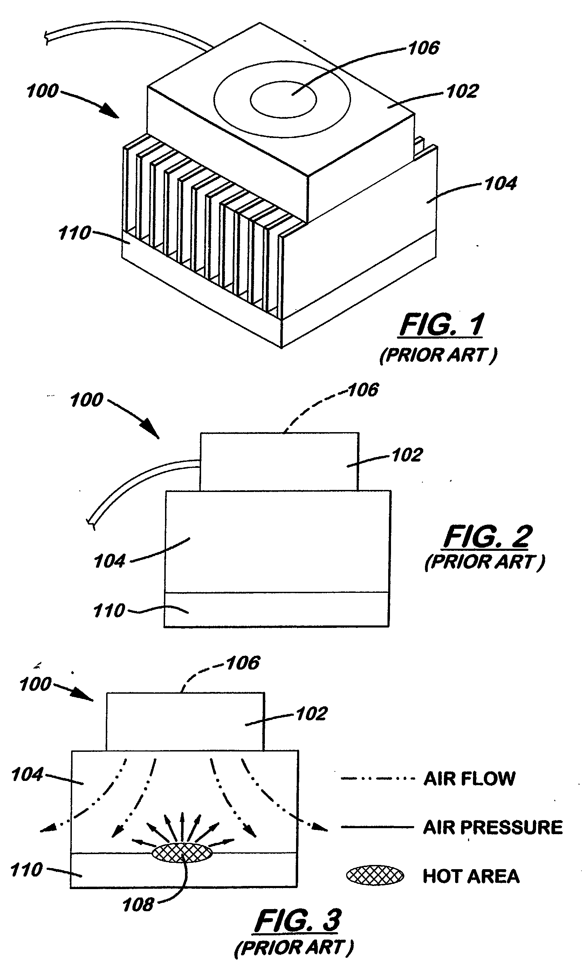

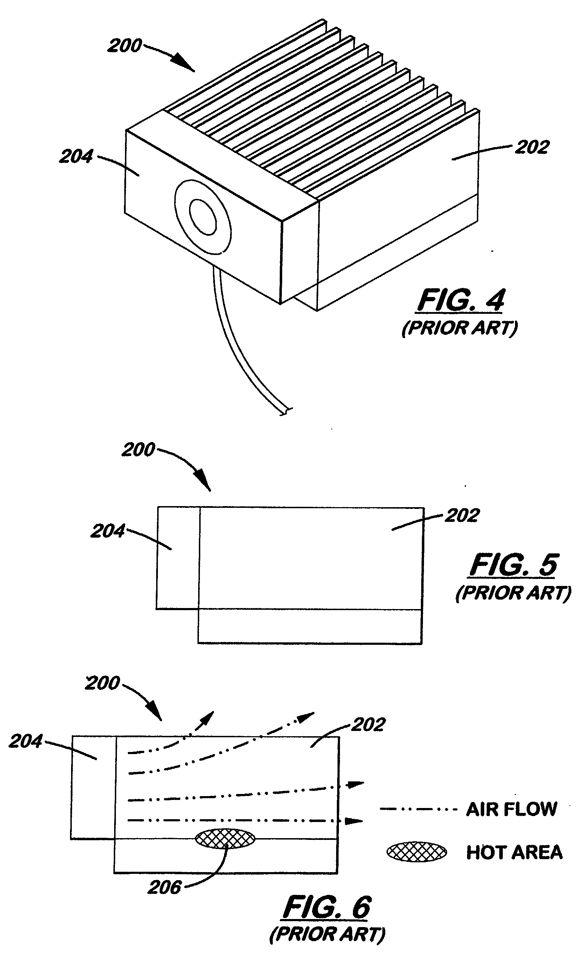

The fan of the fan sink is mounted either on the top of or to the side of the heat sink depending on the requirements of the specific application. FIGS. 1, 2 and 3 illustrate an example of a conventional top-mounted fan sink 100. The fan sink 100 includes a fan assembly 102 mounted on top of a heat sink 104. As shown in FIG. 3, the fan assembly102 blows air downward into the heat sink 104. However, no air is blown under the hub of the fan 106. Therefore, airflow over the hot area 108 of the heat sink 104 is very poor (*i*.*e*., the airflow has low velocity), causing less heat to be dissipated from the electronic device 110. Moreover, the downward airflow increases air pressure within the heat sink 104. This increased air pressure causes additional noise to be produced by the fan 102.

FIGS. 4, 5 and 6 show an example of a conventional side-mounted fan sink 200. The fan sink 200 includes a fan 202 mounted on the side of a heat sink 204. Unlike the top-mounted fan sink 100 described above with reference to FIGS. 1 through 3, the side-mounted fan sink 200 does not substantially increase air pressure within the heat sink 202, permitting the fan 204 to produce lower levels of noise. However, airflow over the hot area 206 of the heat sink 202 is still poor, as most of the airflow does not contribute to dissipation of heat from the hot area 206. Consequently, the thermal efficiency of the fan sink 200 is reduced. Further, the side-mounted fan sink restricts the height of other components mounted on the computer's motherboard.

Therefore, it would be advantageous to provide a fan sink furnishing increased airflow over the hot area of the electronic device, resulting in increased thermal efficiency. It would also be desirable that such a fan sink would reduce noise caused by air pressure within the heat sink and would not restrict the height of other components mounted on the computer's motherboard.

### SUMMARY OF THE INVENTION

Accordingly, the present invention is directed to an angle-mounted fan sink for an electronic device, such as a processor mounted to the motherboard of a computer system, or the like. The fan sink includes a heat sink coupled to a surface of the electronic device for conducting heat away from the electronic device. A fan assembly is mounted in an oblique orientation to the base of the heat sink. The fan assembly circulates a cooling medium such as air over the heat sink at an angle that is generally oblique to the surface of the electronic device for dissipating heat from the heat sink. The angled mount of the fan assembly over the heat sink produces increased airflow over the hot area of the electronic device, resulting in increased thermal efficiency. The angled mount also reduces noise due to air pressure and does not restrict the height of other components mounted on the computer's motherboard.

It is to be understood that both the forgoing general description and the following detailed description are exemplary and explanatory only and are not restrictive of the invention as claimed. The accompanying drawings, which are incorporated in and constitute a part of the specification, illustrate an embodiment of the invention and together with the general description, serve to explain the principles of the invention.

### BRIEF DESCRIPTION OF THE DRAWINGS

The numerous advantages of the present invention may be better understood by those skilled in the art by reference to the accompanying figures in which:
FIG. 1 is an isometric view illustrating a conventional top-mounted fan sink;
FIG. 2 is a side elevational view illustrating the top-mounted fan sink shown in FIG. 1;
FIG. 3 is a block diagram illustrating operation of the top-mounted fan sink shown in FIGS. 1 and 2.
FIG. 4 is an isometric view illustrating a conventional side-mounted fan sink;
FIG. 5 is a side elevational view illustrating the side-mounted fan sink shown in FIG. 4;
FIG. 6 is a block diagram illustrating operation of the side-mounted fan sink shown in FIGS. 4 and 5.
FIG. 7 is an isometric view illustrating an angle-mounted fan sink in accordance with an exemplary embodiment of the present invention.
FIG. 8 is a side elevational view illustrating the angle-mounted fan sink shown in FIG. 7.
FIG. 9 is a block diagram illustrating operation of the angle-mounted fan sink shown in FIGS. 7and 8, and
FIG. 10 is a graph comparing the temperature measured within the heat sink of the angle-mounted fan sink and a conventional horizontal mounted fan-sink.

### DETAILED DESCRIPTION OF THE INVENTION

Reference will now be made in detail to the presently preferred embodiments of the invention, examples of which are illustrated in the accompanying drawings.

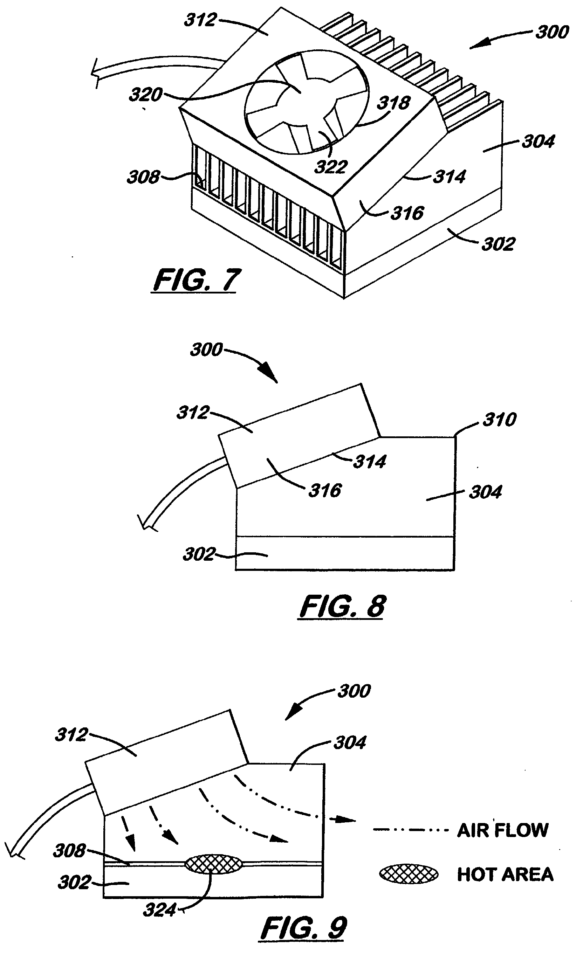

Referring generally now to FIGS. 7 through 9, an angle-mounted fan sink in accordance with an exemplary embodiment of the present invention is described. The angle-mounted fan sink 300 is suitable for cooling an electronic device 302, in particular, an integrated circuit (IC) device such as a computer processor, co-processor, memory, or the like, mounted to the mother board of a computer system, by dissipating heat into the surrounding air. The fan sink 300 includes a heat sink 304 coupled to a surface 306 of the electronic device 302 for transferring heat away from the electronic device 302 utilizing conduction as the primary heat transfer mechanism. In exemplary embodiments of the invention, heat sink 304 includes a base 308 thermally coupled to the surface 306 of the electronic device 302. At least one fin 310 (a heat sink 304 having a plurality of fins 310 is shown) extends outwardly from base 308 for dissipating heat transferred from the electronic device 302 to base 308 to the surrounding environment, primarily via convection and radiation.

In FIGS. 7 and 8, a heat sink 304 having a plurality of thin plate-like fins 310 extending outwardly from base 308 is illustrated. However, it will be appreciated by those of skill in the art that heat sinks suitable for use by the present invention may comprise fins having other shapes (e.g., rod shaped, curved, angled, etc.) depending on the particular heat transfer requirements of the application in which the fan sink is used. Consequently, substitution of such heat sinks for the heat sink 304 illustrated in FIGS. 7 and 8 would not depart from the scope and spirit of the present invention.

A fan assembly 312 is mounted in an oblique orientation to the base 308 of heat sink 304. The fan assembly 312 circulates a cooling medium over heat sink 304 at an angle that is generally oblique to base 308 and thus oblique to surface 306 of the electronic device 302 to which the base 308 is attached. The flow of the cooling medium over the heat sink 304 promotes dissipation of heat from the heat sink 304 thereby increasing the amount of cooling available for the electronic device 302. In exemplary embodiments, the cooling medium comprises ambient air surrounding the fan-sink 300 and electronic device 302. However, it will be appreciated that the fan-sink 300 of the present invention may be used with other gaseous or liquid cooling mediums without departing from the scope and spirit of the present invention.

In the embodiment of the invention illustrated in FIGS. 7 and 8, fins 310 of heat sink 304 may be formed to include edges 314 that are obliquely angled to the base 308. Fan assembly 312 is abutted against edge 314 so that it is mounted at an angle that is generally oblique to base 308 and thus oblique to surface 306 of the electronic device 302 to which the base 308 is attached. In exemplary embodiments, fan assembly 312 comprises a housing 316 mounted to heat sink 304. A radial fan 318 powered by a small electric motor 320 is disposed within the housing 316 so that the vanes 322 of the radial fan 318 are substantially contained therein to prevent incidental contact between the vanes 320 and external objects such as cabling, circuit cards, or the like. The radial fan 318 circulates the cooling medium (e.g., air) through the fins 310 of heat sink 304 at an oblique angle to the base 310 of the heat sink 304.

Referring now to FIG. 9, the oblique angle at which fan assembly 312 is mounted with respect to heat sink 304 produces greater airflow over the hot area (illustrated by area 324) of heat sink 304 caused by heat generated by electronic device 302. This increased airflow improves the thermal efficiency of the fan sink compared to typical top-mounted or side mounted fan sinks (e.g., fan sinks 100 & 200 shown in FIGS 1 and 2). For example, for an exemplary top mounted fan sink 100 shown in FIGS. 1 through 3 using a 6 Watt (12V x 0.5A) fan assembly, the air flow measured at 0.5 inches above hot area 108 has been measured to be approximately 300 to 400 feet per minute. However, for the angle mounted fan sink 300 (FIGS. 7 through 9) of the present invention, the air flow measured at 0.5 inches above the hot area 326 is increased to approximately 1500 to 1800 feet per minute using a 6 Watt (12V x 0.5A) fan assembly 312. The angle mounted fan sink 300 also produces less audible noise than comparable top mounted fan sinks (such as fan sink 100 shown in FIG. 1). The oblique angle at which fan assembly 312 is mounted with respect to heat sink 304 results in air flowing through the heat sink at a generally oblique angle to base 308 instead of directly downward toward the base. This airflow pattern reduces the air pressure within the heat sink 304 in comparison to top mounted fan sinks such as fan sink 100 shown in FIG. 1 resulting in less fan noise. Moreover, unlike conventional side mounted fan sinks, the angle mounted fan assembly 312 does not restrict the height of other components adjacent to the electronic device 302. (*e*.*g*., mounted on the circuit board or motherboard to which the electronic device 302 is mounted).

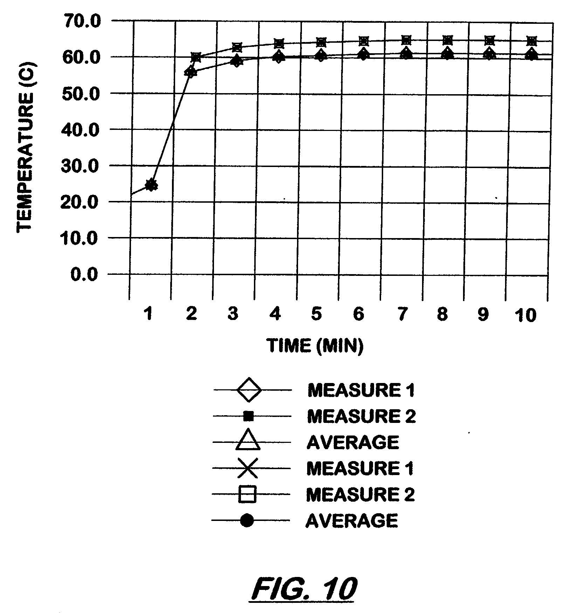

Turning now to FIG. 10, the operation of an exemplary angle-mounted fan sink 300 (FIGS. 7, 8 and 9) in accordance with the present invention and a conventional top-mounted fan sink 100 (FIGS. 1, 2 and 3) are compared. For the comparison illustrated by FIG. 10, exemplary fan sinks 100 & 300 each employ a 6 Watt (12V x 0.5A) fan assembly 110 & 312.

**TABLE 1**

| | **ANGLE MOUNTED FAN SINK** | | | **TOP MOUNTED FAN SINK** | | |
|---|---|---|---|---|---|---|
| Time (min) | Measure 1 | Measure 2 | Average | Measure 1 | Measure 2 | Average |
| 0 | 24.7 | 24.8 | **24.8** | 25.0 | 25.5 | **25.3** |
| 1 | 55.8 | 56.0 | **55.9** | 59.6 | 59.7 | **59.7** |
| 2 | 59.9 | 59.9 | **59.9** | 63.2 | 63.5 | **63.4** |
| 3 | 61.2 | 61.4 | **61.3** | 64.4 | 64.6 | **64.5** |
| 4 | 61.6 | 61.7 | **61.7** | 64.8 | 65.0 | **64.9** |
| 5 | 61.8 | 61.8 | **61.8** | 65.0 | 65.3 | **65.2** |
| 6 | 61.9 | 61.8 | **61.9** | 65.0 | 65.5 | **65.3** |
| 7 | 62.0 | 61.9 | **62.0** | 65.1 | 65.5 | **65.3** |
| 8 | 62.0 | 62.0 | **62.0** | 65.2 | 65.5 | **65.4** |
| 9 | 62.0 | 62.1 | **62.1** | 65.2 | 65.5 | **65.4** |

As shown in FIG. 10 and summarized in Table 1, when the fan assemblies of both fan sinks 100 & 300 are run at maximum speed, the angle mounted fan sink 300 cools the electronic device 302 by more than 3° C relative to the amount of cooling provided to electronic device 110 by top-mounted fan sink 100 (wherein electronic devices 302 & 110 are thermally identical). This improvement in cooling capacity is possible even though heat sink 304 has a smaller surface area than the fins of heat sink 100 due the formation of edges 314 that are obliquely angled to the base 308.

Alternately, instead of providing increased cooling capacity, it may be possible to reduce the speed of fan assembly 312 without degrading the cooling capacity of the fan sink 300 in comparison to top or side mounted fan sinks 100 & 200. For example, for the fan sinks 100 & 300 described in the discussion of FIG. 10 (which use a 6 Watt (12V x 0.5A) fan assembly 102 & 312), the speed of fan assembly 312 may be reduced by approximately 30% while allowing the angle mounted fan sink 300 to maintain approximately the same thermal efficiency as the top-mounted fan sink 100 (*i.e*., cool the electronic device to approximately 65.5 ° C). In this manner, the fan assembly 312 may be run at 9 volts, saving energy and extending the life of the fan motor 320.

Thus, there has been described an angle-mounted fan sink 300 for an electronic device 302, in particular an integrated circuit (IC) device such as a computer processor, co-processor, memory, or the like, wherein the fan assembly 312 is mounted in an oblique orientation (*i*.*e*., at an angle) to the base 308 of the heat sink 304. The angled mount of the fan 312 over the heat sink 304 produces higher air flow over the hot area 326 of the electronic device 302 (*i.e*., high velocity, such as 1500 to 1800 feet per minute), thus resulting in increased thermal efficiency. The angle-mounted fan sink 300 also reduces noise due to air pressure within the heat sink and does not restrict the height of other components mounted on the computer's motherboard.

It is believed that the angle-mounted fan sink of the present invention and many of its attendant advantages will be understood by the forgoing description. It is also believed that it will be apparent that various changes may be made in the form, construction and arrangement of the components thereof without departing from the scope and spirit of the invention or without sacrificing all of its material advantages. The form herein before described being merely an explanatory embodiment thereof. It is the intention of the following claims to encompass and include such changes.

## Claims

1. A fan sink for an electronic device, comprising:
a heat sink suitable for being coupled to a surface of the electronic device for conducting heat away from the electronic device; and
a fan assembly for circulating a cooling medium over the heat sink,
wherein the fan assembly circulates the cooling medium through the heat sink at an angle that is generally oblique to the surface of the electronic device.

2. The fan sink as claimed in claim 1, wherein the fan assembly is mounted to the heat sink at an oblique angle to the surface of the electronic device.

3. The fan sink as claimed in claim 1, wherein the heat sink includes a base suitable for being mounted to the surface of the electronic device and at least one fin extending outwardly from the base, the cooling medium being circulated over the at least one fin for dissipating heat therefrom.

4. The fan sink as claimed in claim 3, wherein the at least one fin comprises an edge obliquely angled to the base, the fan assembly being abutted to the edge so that it is mounted at an oblique angle to the surface of the electronic device.

5. The fan sink as claimed in claim 1, wherein the fan assembly comprises a radial fan.

6. The fan sink as claimed in claim 1, wherein the electronic device comprises a processor.

7. The fan sink as claimed in claim 1, wherein the cooling medium comprises air.

8. A fan sink for an electronic device, comprising:
a heat sink suitable for being coupled to a surface of the electronic device for conducting heat away from the electronic device; and
a fan assembly mounted to the heat sink at an oblique angle to the surface of the electronic device, the fan assembly for circulating a cooling medium over the heat sink,
wherein the fan assembly circulates the cooling medium through the heat sink at an angle that is generally oblique to the surface of the electronic device.

9. The fan sink as claimed in claim 8, wherein the heat sink includes a base suitable for being mounted to the surface of the electronic device and a plurality of fins extending outwardly from the base, the cooling medium being circulated over the plurality of fins for dissipating heat therefrom.

10. The fan sink as claimed in claim 9, wherein the plurality of fins comprise edges obliquely angled to the base, the fan assembly being abutted to the edges.

11. The fan sink as claimed in claim 8, wherein the fan assembly comprises a radial fan.

12. The fan sink as claimed in claim 8, wherein the electronic device comprises a processor.

13. The fan sink as claimed in claim 8, wherein the cooling medium comprises air.

14. A fan sink for an electronic device, comprising:
means suitable for being coupled to a surface of the electronic device for conducting heat away from the electronic device; and
means for circulating a cooling medium over conducting means,
wherein the circulating means circulates the cooling medium through the conducting means at an angle that is generally oblique to the surface of the electronic device.

15. The fan sink as claimed in claim 14, wherein the circulating means is mounted to the conducting means at an oblique angle to the surface of the electronic device.

16. The fan sink as claimed in claim 14, wherein the conducting means includes a base mounted to the surface of the electronic device and at least one fin extending outwardly from the base, the cooling medium being circulated over the at least one fin for dissipating heat therefrom.

17. The fan sink as claimed in claim 16, wherein the at least one fin comprises an edge obliquely angled to the base, the fan assembly being abutted to the edge so that it is mounted at an oblique angle to the surface of the electronic device.

18. The fan sink as claimed in claim 1, wherein the circulating means comprises a radial fan.

19. The fan sink as claimed in claim 1, wherein the electronic device comprises a processor.

20. The fan sink as claimed in claim 1, wherein the cooling medium comprises air.
